Europäisches Patentamt

European Patent Office

Office européen des brevets

(19)

(11) Publication number: **0 196 874**
A2

(12)

# EUROPEAN PATENT APPLICATION

(21) Application number: 86302255.4

(22) Date of filing: 26.03.86

(51) Int. Cl.⁴: **H 05 K 3/00**

(30) Priority: 26.03.85 US 716272

(43) Date of publication of application:
08.10.86 Bulletin 86/41

(84) Designated Contracting States:
CH DE FR GB IT LI SE

(71) Applicant: ILLINOIS TOOL WORKS INC.
8501 West Higgins Road
Chicago Illinois 60631(US)

(72) Inventor: Valaoras, George T.
647 Thompsons Way
Inverness Illinois 60067(US)

(74) Representative: Rackham, Stephen Neil et al,
GILL JENNINGS & EVERY 53-64 Chancery Lane
London WC2A 1HN(GB)

(54) Processing a flexible substrate.

(57) A method of processing a bi-axially oriented substrate to enable it to withstand an elevated temperature without significant physical dimensional variation comprises heating the substrate from an ambient temperature to a processing temperature, which is sufficiently high to randomize the molecular bond, maintaining the substrate at the processing temperature for a time sufficient to effect the randomization of substantially all of the molecular bonds in the substrate, and allowing the substrate to substantially cool to its ambient temperature. Preferably a compressive force is applied to the substrate along an axis substantially perpendicular to its bi-axial orientation during heating.

0196874

## Processing A Flexible Substrate

As the technology for surface mounting electronic components to substrates continues to gain acceptance in today's marketplace, and as the ever-present pressure to reduce costs of manufacture is considered, there is an increasing need in the electronics industry for a flexible substrate capable of withstanding the rigors and high temperatures of processes employed for surface mounting of electrical components to substrates, which substrate must be less expensive than presently available flexible substrates in order that surface mounting of components to flexible substrates may be more competitive in today's marketplace.

Presently utilized materials for flexible substrates in the electronics industry which are adaptable for some surface mounting applications and capable of withstanding the rigors and elevated temperatures involved with automated processing techniques for surface mounted techniques in volume production operations such as vapour phase reflow soldering which takes place at substantially 215°C include such materials as KAPTON (a registered trademark of E.I. DuPont DeNemours Corp.). While presently known flexible substrate materials are capable of meeting the operational parameters required for surface mounting applications, they are expensive as compared to other commercially available materials, such as polyethylene terephthalate (commercially known as MYLAR. MYLAR is a registered trademark of E.I. DuPont DeNemours Corp.).

It would be of significant benefit to the electronics industry to be able to utilize the cheaper film materials such as MYLAR for flexible substrates in surface mounted applications.

The present invention is directed to a method for processing plastic film materials, such as MYLAR, to render those cheaper substrates capable of withstanding an elevated temperature without significant physical dimensional variation or deterioration.

The requirement for limitation of physical dimensional variation is especially important in order that the integrity of the electrical circuitry affixed to the substrate may be able to maintain its electrical integrity and its physical integrity during processing. If the substrate significantly changes in its physical dimensions during processing, then the electrical circuitry carried thereon, be it printed on the substrate or otherwise affixed, will undergo significant physical stresses which may likely cause breaks in the electrical continuity of the circuit paths or other circuit elements carried on the substrate. Thus, it is of significant importance that the flexible substrate undergo its required processing without changing its physical dimensions.

The invention is a method for processing a flexible substrate to render that substrate capable of withstanding an elevated temperature without significant physical dimensional variation where the substrate is substantially comprised of a plastic film material having molecular bonds oriented in a first axis and a second axis. The method involves the steps of raising the substrate from an ambient temperature to a processing temperature, which processing temperature is sufficiently high to randomize the molecular bonds of the plastic film material; maintaining that substrate at the processing temperature for a processing time sufficient to effect the randomization of substantially all of the molecular bonds in the plastic film material; and allowing the substrate to substantially cool to the ambient temperature.

In an alternate embodiment of the present invention, a compressive force is applied in an axis substantially perpendicular to the two axes of the molecular bonds of the plastic film material prior to elevating the temperature of the plastic film material from the ambient temperature to the processing temperature, and that compressive force is maintained throughout the process until the plastic film material substantially cools to the ambient temperature.

It is therefore an object of the present invention to provide a method for processing a plastic film material to render that plastic film material capable of withstanding an elevated temperature without physical dimensional variation and thereby rendering that plastic film material capable of use as a flexible substrate capable of withstanding the rigors and elevated temperatures of automated processing techniques employed in surface mounting of electrical components to the substrate.

Particular examples of the method in accordance with this invention will now be described with reference to the accompanying drawings; in which:-

Figure 1 is a flow diagram of the preferred embodiment of the present invention; and,

Figure 2 is a flow diagram of an alternate embodiment of the present invention.

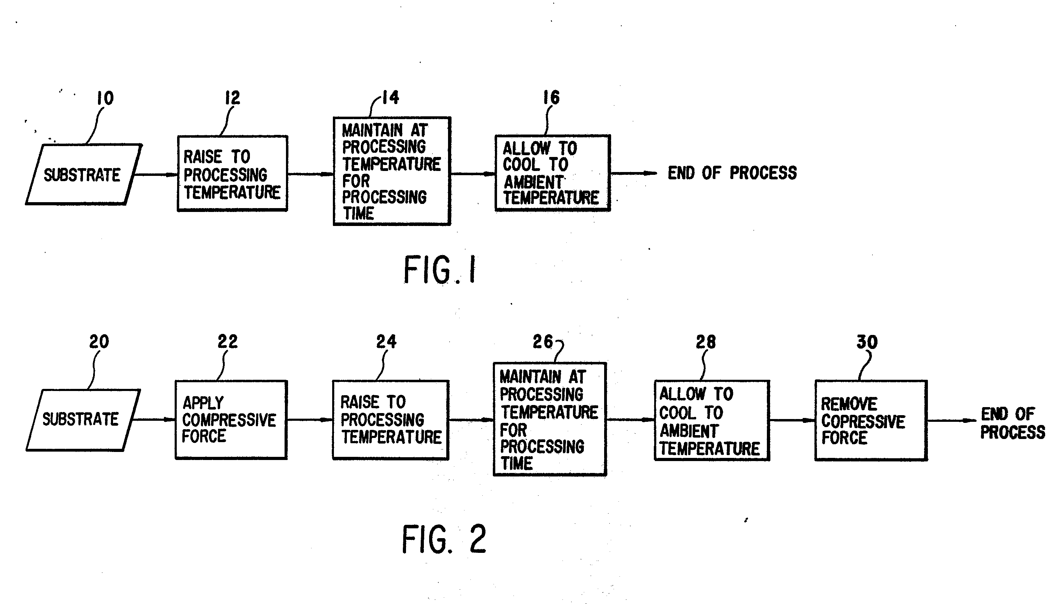

Referring to Figure 1, a plastic substrate is selected (box 10). The plastic film generally contemplated to be processed by the method of the present invention is bi-axially oriented with a length L and a width W in a manner whereby the film is simultaneously stretched such that the ratios of the change of length with respect to length ($\Delta$L over L) and the change of width with respect to width ($\Delta$W over W) are constant.

If an unrestrained sheet of such orientation is heated, it will shrink. However, since its initial volume must equal its final volume and since L and W will shrink in proportion to their initial elongation, T (the thickness of the substrate) correspondingly increases to maintain a constant volume. It is such changes in physical dimensions which it is the intent of this invention to prevent during processing of the substrate at elevated temperatures such as would be expected to be encountered during automated processing for surface mounting of devices to the substrate.

Having selected the substrate, as indicated by block 10 of Fig. 1, the substrate is then raised to a processing temperature (block 12). The processing temperature is selected to be sufficiently high to randomize the molecular bonds of the bi-axial orientation of the substrate. Of course, the processing temperature must remain below a level at which the substrate will be destroyed.

For example, it is known that MYLAR® (MYLAR is a registered trademark of the E.I. DuPont DeNemours Corp.) plastic film melts at approximately 250° C. A convenient processing temperature for practice of this invention has been found to be 205° C; however, this invention is not intended to be limited to that temperature as a processing temperature.

Once the sheet is raised to the processing temperature (block 12, Fig. 1), it is maintained at that processing temperature for a processing time (block 14, Fig. 1), which processing time is a sufficient time to effect randomization of substantially all of the molecular bonds of the bi-axial structure of the substrate.

It has been found that an appropriate processing time for effectuation of the step indicated at block 14 of Fig. 1 is generally two hours; however, of course, it is not intended that the scope of the invention disclosed hereby be limited to that processing time.

Following the lapse of the processing time and, therefore, completion of the step represented at block 14 of Fig. 1, the substrate is allowed to cool (block 16, Fig. 1), and thus ends the process.

By the method of the present invention, the substrate's "memory" of its original bi-axial orientation is erased. Thereafter the substrate can be elevated to at least the processing temperature during its further handling and involvement in attachment with electrical components with negligible, if any shrinkage of length L or width W. The plastic film of the substrate, subjected to processing by the method of the present invention, is stripped of its memory to shrink further at temperatures at least up to the processing temperature.

This memory erasure of the material of the substrate at elevated processing temperatures is extremely important where circuit paths have been screen printed or otherwise affixed to the flexible substrate. If length L, or width W, or both of those dimensions change during further processing of the substrate, that physical displacement of the substrate material could likely result in electrical discontinuities in circuit traces and thereby render any circuitry involving such circuit traces inoperable.

Thus, by the method of the present invention, cheaper plastic materials, not heretofore considered capable of withstanding the elevated temperatures of automated processes involved in surface mounting techniques for production volume operations are, indeed, rendered capable of withstanding such temperatures without suffering dimensional variations. As a consequence, more expensive, specialized materials such as KAPTON® may be replaced by cheaper materials, which replacement was heretofore thought impossible.

Referring to Fig. 2, an alternate embodiment of the present invention is disclosed. The embodiment of the method illustrated by Fig. 2 contemplates production of a plastic substrate capable of withstanding the elevated temperatures of surface mounting techniques encountered in volume production operations where it is necessary to insure that the length L, the width W, and the thickness T of the material do not significantly change during such high temperature processing.

In Fig. 2, a substrate is chosen (block 20 of Fig. 2). The substrate chosen (block 20) is contemplated by this alternate embodiment of the invention to be the same type of material as is contemplated in connection with block 10 of Fig. 1: A plastic film which, during its manufacture, is bi-axially oriented with a length L and a width W in a manner whereby the film is simultaneously stretched such that the ratios of the change of length with respect to length ($\triangle$L over L) and the change of width with respect to width ($\triangle$W over W) are constant.  Once the substrate is chosen (block 20), the substrate is subjected to a compressive force (block 22).  The compressive force is applied in an axis substantially perpendicular to the plane defined by the two axes of the bi-axial orientation of the substrate material and is controlled a level to prevent the substrate material from extruding at the processing temperature.

Thus, the thickness T of the substrate material is restrained during the duration of the practice of the method of this invention.  Since the thickness T cannot increase because of the compressive force applied thereto, neither length L nor width W of the substrate can decrease since the volume of the substrate must remain constant.  After application of the compressive force, the substrate, with the compressive force still applied, is raised to a processing temperature (block 24 of Fig. 2), which processing temperature is sufficiently high to randomize the molecular bonds of the substrate material.  Of course, the processing temperature must remain below the level at which the substrate will be destroyed.

The substrate is maintained at the processing temperature for a processing time (block 26 of Fig. 2), which processing time is sufficient to effect randomization of substantially all of the molecular bonds of the substrate material. The compressive force is maintained to restrict the thickness T of the substrate material throughout the processing time represented at block 26 of Fig. 2.

A representative temperature for the processing temperature for this alternate embodiment of the present invention is 205° C and a representative processing time for this alternate embodiment of the present invention is two hours; however, this disclosure is not intended in any way to be restricted to that processing temperature or that processing time.

Upon the lapse of the processing time, the substrate is allowed to cool to its initial ambient temperature (block 28 of Fig. 2), and after the substrate has cooled to its initial ambient temperature, the compressive force is removed therefrom (block 30, Fig. 2). The process is then completed.

By application of the alternate embodiment of the present invention, the substrate's "memory" of its original bi-axial orientation is erased. Thereafter the film can be elevated to at least the processing temperature during its further handling and involvement in elevated temperature operations with negligible, if any shrinkage of length L or width W, even in the absence of restraint of thickness T during such further handling.

An important consequence of this alternate embodiment of the invention is that one need not construct the substrate with a greater length L and width W than is desired with the end-product substrate, in anticipation of shrinkage of length L and width W during processing by the method of this invention. By restraining the thickness T with the compressive force (block 22, Fig. 2), the substrate is prevented from changing in thickness T during processing and, since the volume of the substrate must remain constant, neither length L nor width W can change during practice of the method of this invention. Thus, the film's "memory" of its origi-

0196874

nal bi-axial orientation is erased without any change in length L, width W, or thickness T. And the substrate can be further handled at elevated temperatures to at least the processing temperature with negligible, if any change of length L, width W, or thickness T during such further handling.

CLAIMS

1. A method for processing a flexible substrate to render said substrate capable of withstanding an elevated temperature without significant physical dimensional variation, the substrate comprising a plastic film material having molecular bonds oriented in a first axis and a second axis, and the method comprising the steps of:

heating the substrate from an ambient temperature to a processing temperature which is sufficiently high to randomize the molecular bonds;

maintaining the substrate at the processing temperature for a processing time sufficient to effect the randomization of substantially all of the molecular bonds in the substrate; and,

allowing the substrate to cool to the ambient temperature.

2. A method according to claim 1, which also includes the steps of:

applying a compressive force to the substrate along a third axis which is substantially perpendicular to the first and second axes; and,

maintaining the compressive force upon the substrate whilst heating the substrate and substantially until the substrate cools to ambient temperature.

3. A method according to claim 1 or 2, in which the processing temperature is less than or equal to the elevated temperature.

4. A method according to claim 1 or 2, in which the processing temperature is equal to or greater than the elevated temperature.

5. A method according to any one of the preceding claims, in which the plastic film material is polyethylene terephthalate film.

FIG. 1

FIG. 2